# EUROPÄISCHE PATENTSCHRIFT

(11) **EP 1 954 853 B1**
(45) Veröffentlichungstag und Bekanntmachung des Hinweises auf die Patenterteilung: **02.11.2011**
(21) Anmeldenummer: 06830064.9
(22) Anmeldetag: 21.11.2006
(51) Int. Cl.: C23C 16/455

(54) **CVD-REAKTOR MIT EINEM GASEINLASSORGAN**
CVD REACTOR WITH A GAS INLET MEMBER
REACTEUR DE CVD DOTE D'UN ORGANE D'ADMISSION DE GAZ

(30) Priorität: 25.11.2005 DE 102005056320
(43) Veröffentlichungstag der Anmeldung: 13.08.2008
(73) Patentinhaber: Aixtron SE, 52134 Herzogenrath (DE)
(72) Erfinder: DAUELSBERG, Martin, 52074 Aachen (DE); KÄPPELER, Johannes, 52146 Würselen (DE); MARTIN, Conor, Crows Nest 2065 SW, Sydney (AU)
(74) Vertreter: Grundmann, Dirk
(86) Internationale Anmeldenummer: PCT/EP2006/068716
(87) Internationale Veröffentlichungsnummer: WO 2007/060161

(56) Entgegenhaltungen:
- WO-A-02/24985
- DE-A1- 10 057 134
- US-A- 5 244 694
- US-A- 5 819 684
- US-A1- 2002 179 586

## Beschreibung

Die Erfindung betrifft eine Vorrichtung zum Abscheiden mindestens einer Schicht auf einem Substrat mittels eines Prozessgases, das durch einen sich in Vertikalrichtung erstreckenden Strömungskanal eines in Bezug auf ein Reaktorgehäuse ortsfesten Gaseinlassorgans in eine sich in Horizontalrichtung erstreckende Prozesskammer eingebracht wird, wobei das Prozessgas aus einer Gasaustrittsöffnung eines in das Zentrum der rotationssymmetrischen Prozesskammer ragenden Abschnitts des Gaseinlassorganes austritt und über einen sich in Horizontalrichtung erstreckenden, um das Zentrum rotierenden Boden der Prozesskammer in Radialauswärtsrichtung strömt, auf welchem das Substrat liegt.

Die Funktionsweise der oben genannten Vorrichtung wird beispielsweise in der DE 10057134 A1 beschrieben. Diese Schrift beschreibt einen MOCVD-Reaktor mit einer rotationssymmetrischen Prozesskammer. Durch ein im Zentrum und entlang der Achse der Prozesskammer angeordnetes Gaseinlassorgan werden zusammen mit Trägergasen zwei oder mehrere Prozessgase in die Prozesskammer eingeleitet. Der Zustrom der Prozessgase erfolgt in Achsrichtung, also in Vertikalrichtung. Das Gaseinlassorgan lenkt die Prozessgase dann in eine Horizontalrichtung um. In dieser Richtung strömen die beiden Prozessgase über den Boden der Prozesskammer, der von einem Suszeptorhalter gebildet ist, welcher selbst eine Vielzahl von Suszeptoren trägt, die jeweils ein Substrat tragen, das beschichtet werden soll. Dort sind zwei in Vertikalrichtung übereinander angeordnete Austrittsöffnungen für je ein Prozessgas vorgesehen. Aus der unteren Austrittsöffnung soll ein Hydrid und aus der oberen Austrittsöffnung eine metallorganische Komponente jeweils mit einem Trägergas austreten. Die Austrittsöffnungen liegen auf einer Zylindermantelfläche.

Die DE 10133914 A1 beschreibt ebenfalls einen MOCVD-Reaktor mit einem drehbaren Suszeptorhalter und einem ortsfesten Gaseinlassorgan, das sich im Drehzentrum befindet und aus welchem die Prozessgase austreten. Auch hier tritt das Hydrid aus einer unteren Austrittsöffnung aus. Auch hier wird die untere Wandung dieser Austrittsöffnung von dem Boden der Prozesskammer ausgebildet.

Die DE 10153463 A1 beschreibt einen MOCVD-Reaktor mit einem drehangetriebenen Prozesskammerboden. Oberhalb des Bodens befindet sich im Zentrum der Prozesskammer ein Gaseinlassorgan mit einer stirnseitigen Öffnung, aus welcher das Hydrid austritt. Eine zweite Austrittsöffnung befindet sich direkt unterhalb der Prozesskammerdecke. Die Austrittsöffnung besitzt eine Zylindermantelförm und wird von einer Fritte ausgebildet. Rückwärtig der Austrittsöffnung ist eine Gasumlenkfläche vorgesehen, die eine gekrümmte Oberfläche aufweist.

Aus der US 4,976,996 ist ein CVD-Reaktor bekannt, bei dem die Prozessgase von außen her in eine kreisrunde Prozesskammer eingebracht werden. Dies erfolgt durch Öffnungen in der peripheren Wand der Prozesskammer, deren Boden von einem drehangetriebenen Substrathalter gebildet wird. Am radial äußeren Rand des Substrathalters sind Stromleitkanäle vorgesehen. Ähnliche Stromleitkanäle befinden sich Zentrum des Substrathalters, durch welches auch die Gase aus der Prozesskammer entfernt werden.

Aus der JP 2005072314 ist ein CVD-Reaktor bekannt, bei dem die Gase ins Zentrum einer im Wesentlichen kreisförmigen Prozesskammer, eingeleitet werden. Die Prozessgase durchströmen auch hier die Prozesskammer in Horizontalrichtung, allerdings von innen nach außen.

Die US 5,221,556 und JP 2004200225 beschreiben Horizontalreaktoren, bei denen drehangetriebene Substrathalter, auf denen jeweils ein Substrat aufliegt, in Diagonalrichtung überströmt werden.

Ausgehend von dem vorgenannten Stand der Technik liegt der Erfindung die Aufgabe zugrunde, den Gasfluss unmittelbar oberhalb des Bodens der Prozesskammer zu verbessern.

Gelöst wird die Aufgabe durch die in den Ansprüchen angegebene Erfindung, wobei jeder Anspruch eine eigenständige Lösung der Aufgabe darstellt und jeder Anspruch mit jedem anderen Anspruch kombinierbar ist.

Der Erfindung liegt die Erkenntnis zugrunde, dass bereits geringe Unebenheiten auf dem Substrat zu lokalen Abkühlungen führen können. Darüber hinaus führen geringfügige Unebenheiten auf dem Boden der Prozesskammer zu Wirbeln, die im weiteren Verlauf des Gasstromes zu Wachstumsinhomogenitäten führen können.

Es ist deshalb zunächst und im Wesentlichen vorgesehen, dass der Stirnabschnitt des Gaseinlassorganes in eine topfartige Vertiefung ragt und ein Endabschnitt einer Gasumlenkfläche mit dem Boden fluchtet. Die topfartige Vertiefung ist dem Boden der Prozesskammer und insbesondere des drehangetriebenen Suszeptorhalters zugeordnet. In diese topfartige Vertiefung ragt ein Stirnabschnitt des Gaseinlassorganes ein. Unmittelbar oberhalb dieses Strnabschnittes erstreckt sich die Gasaustrittsöffnung für das Hydrid, bei dem es sich um Arsin, Phosphin oder Ammoniak handeln kann. Diese Austrittsöffnung besitzt eine Rotationssymmetrie. Rückwärtig der Austrittsöffnung befindet sich die rotationssymmetrische Gasumlenkfläche. Der Verlauf deren Endabschnitts geht in die Bodenfläche fluchtend über. Da das Gaseinlassorgan gegenüber dem Reaktorgehäuse ortsfest ist, sich der Suszeptorhalter aber gegenüber dem Gaseinlassorgan dreht, liegt das Gaseinlassorgan nicht in berührender Anlage an den Wänden der Vertiefung. Es sind vielmehr Bewegungsschlitze vorgesehen, so befindet sich zwischen der ebenen Stirnfläche des Gaseinlassorganes und dem Boden der Vertiefung ein geringfügiger Spalt. Auch zwischen der Topfwand und dem Stirnabschnitt des Gaseinlassorganes befindet sich ein Umfangsspalt. Letzterer ist aber so klein bemessen, dass er keine relevante Störung des Gasflusses bildet. Die Gasumlenkfläche ist in Stromrichtung des Gases gerundet. Das Gas tritt aus dem in Vertikalrichtung sich erstreckenden Strömungskanal in den gekrümmten Bereich und wird dort wirbelfrei in eine Horizontalrichtung umgeleitet. Dabei vergrößert sich der effektive Querschnitt des Strömungskanales derartig, dass eine Reduzierung der Strömungsgeschwindigkeit eintritt. Gleichwohl handelt es sich aber bei der gesamten Strömung um eine laminare Strömung. Oberhalb dieser ersten Gasaustrittsöffnung, deren eine Wandung mit dem Boden der Prozesskammer fluchtet, befindet sich mindestens eine weitere zweite Gasaustrittsöffnung für ein zweites Prozessgas, beispielsweise eine metallorganische Komponente. Diese zweite Gasaustrittsöffnung ist mit einem zweiten Strömungskanal verbunden. Das Gasauslassorgan ist bevorzugt aus Edelstahl gefertigt und flüssigkeitsgekühlt. Hierzu kann das Gasauslassorgan einen Zentralbereich aufweisen, der einen Kühlflüssigkeitskanal besitzt. Dieser Kühlflüssigkeitskanal erstreckt sich bis in den Stirnabschnitt des Gaseinlassorganes, welcher in der Vertiefung des Bodens der Prozesskammer einliegt.

In einer Weiterbildung der Erfindung, die eigenständigen Charakter aufweist, besitzt das Gaseinlassorgan eine im wesentlichen zylinderförmige Umrisskontur. Wird die Prozesskammer geöffnet, so entfernt sich das Gaseinlassorgan vom Boden der Prozesskammer. Eine Prozesskammerdecke ist fest aber lösbar mit dem Gaseinlassorgan verbunden. Die Prozesskammerdecke besitzt eine zentrale Öffnung, mit der sie über das Gaseinlassorgan gesteckt werden kann. Die Prozesskammerdecke wird bajonettartig am Gaseinlassorgan gehalten. Hierzu kann das Gaseinlassorgan radial nach außen ragende Vorsprünge aufweisen, die zu entsprechenden Aussparungen der zentralen Öffnung der Prozesskammerdecke korrespondieren. Fluchten diese Aussparungen mit den Vorsprüngen, kann die Prozesskammerdecke über die Vorsprünge verlagert werden. Wird daran anschließend die Prozesskammerdecke geringfügig gedreht, so ruht der Rand der zentralen Öffnung auf den Vorsprüngen. Ausführungsbeispiele der Erfindung werden nachfolgend anhand beigefügter Zeichnungen erläutert. Es zeigen:
- Fig. 1: grob schematisch einen Halbschnitt durch eine Prozesskammer in Vertikalrichtung;

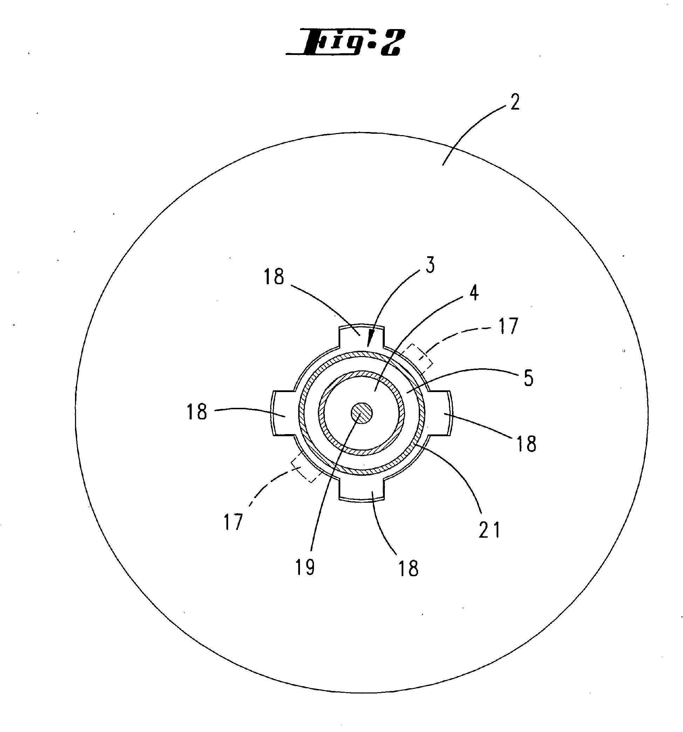

- Fig. 2: eine Draufsicht auf die Prozesskammerdecke mit geschnittenem Gaseinlassorgan und
- Fig. 3: ein weiteres Ausführungsbeispiel der Erfindung in einer Darstellung gemäß Fig.1.

Beim Ausführungsbeispiel handelt es um einen MOCVD-Reaktor. Dieser besitzt ein in den Zeichnungen nicht dargestelltes Reaktorgehäuse, welches beispielsweise aus Edelstahl besteht und gegenüber der Umgebungsatmosphäre gasdicht verschlossen ist. In dieses Reaktorgehäuse werden über geeignete Gasleitungen die Prozessgase und die Trägergase eingeleitet. Als Prozessgase werden metallorganische Verbindungen der dritten oder zweiten Hauptgruppe des Periodensystems verwendet. Weiter werden als Prozessgase Verbindungen der fünften Hauptgruppe des Periodensystems und insbesondere Hydride verwendet. Auch kommen Verbindungen der sechsten Hauptgruppe in Betracht. Darüber hinaus besitzt der Reaktor ein Gasauslassorgan, welches ebenfalls in der Zeichnung nicht dargestellt ist.

Innerhalb des Reaktorgehäuses befindet sich die in der Zeichnung im Halbschnitt aufskizzierte Prozesskammer 1. Diese besitzt einen sich in der Horizontalebene erstreckenden Boden 8'. Mit Abstand gegenüberliegend zum Boden 8' ist eine Prozesskammerdecke 2 vorgesehen. Die Prozesskammerdecke 2 und der Boden 8' sind im wesentlichen rotationssymmetrisch gestaltet. Durch eine zentrale Öffnung der Prozesskammerdecke 2 ragt ein Gaseinlassorgan in die Prozesskammer hinein. Unterhalb der Öffnung der Deckenplatte 2 besitzt der Boden 8' eine topfförmige Aussparung 23. In diese Vertiefung ragt der Stirnabschnitt des Gaseinlassorganes 3 derart hinein, dass zwischen Stirnfläche 3' des Gaseinlassorganes 3 und dem Boden der Vertiefung 23 nur ein kleiner Bewegungsspalt 10 verbleibt. Ein Bewegungsspalt 22 erstreckt sich ringförmig um den in der Vertiefung 23 einliegenden Stirnabschnitt des Gaseinlassorganes 3. Dieser Ringspalt 22 wird nach außen hin durch die Topfwandung begrenzt.

In den Zeichnungen ist der Ringspalt 22 stark vergrößert dargestellt. Dies dient ausschließlich der Verdeutlichung. Grundsätzlich sollte dieser Bewegungsspalt 22 so schmal wie möglich ausgebildet sein.

Während das Gaseinlassorgan drehfest dem Reaktorgehäuse zugeordnet ist, wird der Boden 8' der Prozesskammer 1 während des Beschichtungsprozesses drehangetrieben. Hierzu dient eine im Zentrum angeordnete Antriebswelle 14. Der Boden 8' wird im wesentlichen von einem Suszeptorhalter 8 ausgebildet, der aus Graphit bestehen kann und der von unten mittels einer RF-Heizung beheizbar ist. Der Aufbau des Bodens 8' entspricht im wesentlichen dem Aufbau, den die DE 10153463 A1 beschreibt, weshalb diesbezüglich auf diese Schrift verwiesen wird.

Der Suszeptorhalter 8 besitzt eine ringscheibenförmige Gestalt. Dieser Rotationskörper besitzt auf seiner Oberseite, die der Prozesskammer 1 zugewandt ist, eine Vielzahl von Taschen, in denen Suszeptoren 9 liegen. Die Suszeptoren 9 haben eine Kreisscheibenform und liegen auf einem dynamischen Gaslager. Die das Gaslager erzeugenden Düsen sind so ausgerichtet, dass sie nicht nur ein Drehlager für die Suszeptoren 9 bilden, sondern die Suszeptoren 9 auch drehantreiben. Auf jedem Suszeptor 9 liegt ein zu beschichtendes Substrat.

Im Ausführungsbeispiel wird der Boden der Vertiefung 23 von einer Zugplatte 11 ausgebildet, die drehfest mit einem Zugstück verbunden ist. Unterhalb der Zugplatte 11 befindet sich eine Druckplatte 12. Die Zugplatte 11 und die Druckplatte 12 nehmen den Suszeptorhalter 8 zwischen sich auf. Die axiale Sicherung der Druckplatte 12 erfolgt mittels eines Sicherungsstücks 13.

Die Deckenplatte 2 ist fest am Gaseinlassorgan 3 befestigt. Die Befestigung erfolgt bajonettartig. Hierzu sind an der Außenwandung 21 des Gaseinlassorganes 3 Stützvorsprünge 17 angeordnet, die nach radial außen ragen. Die zentrale Öffnung der Deckenplatte besitzt an den entsprechenden Stellen Aussparungen 18, so dass sie von unten über die Stützvorsprünge 17 gehoben werden kann. Nach einer leichten Drehung der Deckenplatte 2 kann sich diese auf den Stützvorsprüngen 17 abstützen. Die Deckenplatte 2 ist dadurch in einfacher Weise auswechselbar.

Innerhalb des Gaseinlassorganes 3 befinden sich mehrere, im Ausführungsbeispiel zwei, Strömungskanäle 4 und 5. Die Strömungskanäle 4 und 5 sind koaxial zueinander angeordnet. Das Gaseinlassorgan bildet hierzu ein Zentralelement 19 aus, welches im Inneren einen Kühlwasserkanal 24 aufweist, der bis in den Endabschnitt des Gaseinlassorganes 3 ragt.

Die Außenfläche des Zentralelementes 19 verläuft im Endbereich in Achsrichtung gekrümmt. Dies geht mit einer stetigen Vergrößerung des Durchmessers des Zentralelementes 19 einher, die im Stirnabschnitt des Gaseinlassorganes 3 den Durchmesser des Gaseinlassorganes 3 erreicht. Zufolge dieser Querschnittskonturlinie bildet sich eine Gasumlenkfläche 6 aus, die den Gasstrom von einer Vertikalrichtung in eine Horizontalrichtung umleiten. Die Umlenkfläche 6 geht stetig, knick- und stufenfrei aus der Innenwandung des Strömungskanals 4 hervor und verläuft derartig, dass ihr Endabschnitt 6' in Horizontalrichtung verläuft und mit dem Boden 8' der Prozesskammer 1 fluchtet.

Die sich auf einer Zylindermantelfläche erstreckende Austrittsöffnung 4' des Strömungskanals 4 besitzt eine erheblich größere Fläche als die Querschnittsfläche des Strömungskanals 4, so dass die laminare Strömung durch den Strömungskanal 4 geschwindigkeitsvermindert in eine laminare Strömung über den Boden 8' übergeht. Oberhalb der Austrittsöffnung 4' befindet sich eine zweite Austrittsöffnung 5'. Auch diese Austrittsöffnung 5' befindet sich auf einer Zylindermantelfläche. Die Außenwandung des ersten Strömungskanales 4 wird von einem rohrförmigen Mittelelement 20 des Gaseinlassorganes 3 ausgebildet. Die Innenwandung des zweiten Strömungskanales 5 wird von der Außenwandung dieses Mittelelementes 4 ausgebildet, welches in seinem Endbereich ebenfalls eine Gasumlenkfläche 7 ausbildet, die die Strömung durch den zweiten Strömungskanal 5 um 90° umleitet. Auch diese Gasumlenkfläche 7 ist glattwandig. Die Außenwandung des zweiten Strömungskanales 5 wird von dem Außenelement 21 ausgebildet, welches auch die Stützvorsprünge 17 trägt.

Die Stirnfläche 3' des Gaseinlassorganes 3 ist wegen der unmittelbar darüber angeordneten Kühlmittelkanäle 24 kälter als der darunter liegende Boden der Vertiefung 23. Das aus dem Strömungskanal 4 austretende Gas wird sehr schnell auf Prozesstemperatur gebracht. Auch das Mittelelement 20 und das Außenelement 21 können flüssigkeitsgekühlt sein. Die hierzu erforderlichen Kühlmittelkanäle sind der Übersicht halber nicht dargestellt.

Das Reaktorgehäuse ist durch einen Deckel verschlossen. Dieser Deckel kann geöffnet werden. Das Gaseinlassorgan 3 hängt am Deckel. Wird der Deckel geöffnet, so entfernen sich die Deckenplatte 2 und das Gaseinlassorgan 3 vom Boden 8', so dass die Suszeptoren 9 mit Substraten beladen bzw. entladen werden können. Bei dieser Bewegung taucht der Endabschnitt des Gaseinlassorganes 3 aus der Vertiefung 23. Wird der Deckel des Reaktors wieder geschlossen, so taucht der Endabschnitt des Gaseinlassorganes 3 wieder in die Vertiefung 23 ein und schwebt dort über dem Boden der Vertiefung 23 und mit Abstand zu der kreisrunden Wand der Vertiefung 23.

In den Strömungskanälen 4 und 5 befinden sich Drallmischer, die mit der Bezugsziffer 26 bezeichnet sind. Diese Drallmischer bilden eine Druckbarriere für das in die Strömungskanäle 4, 5 eintretende Gas. Durch eine nicht dargestellte spezielle Gasführung im oberen, kalten Abschnitt des Gaseinlassorganes 3 sorgen diese Drallmischer dafür, dass das Gas in Umfangsrichtung gleichmäßig durch die unteren Abschnitte der Strömungskanäle 4, 5 strömt, um in Umfangsrichtung gleichmäßig und homogen aus den Öffnungen 5', 4' auszuströmen.

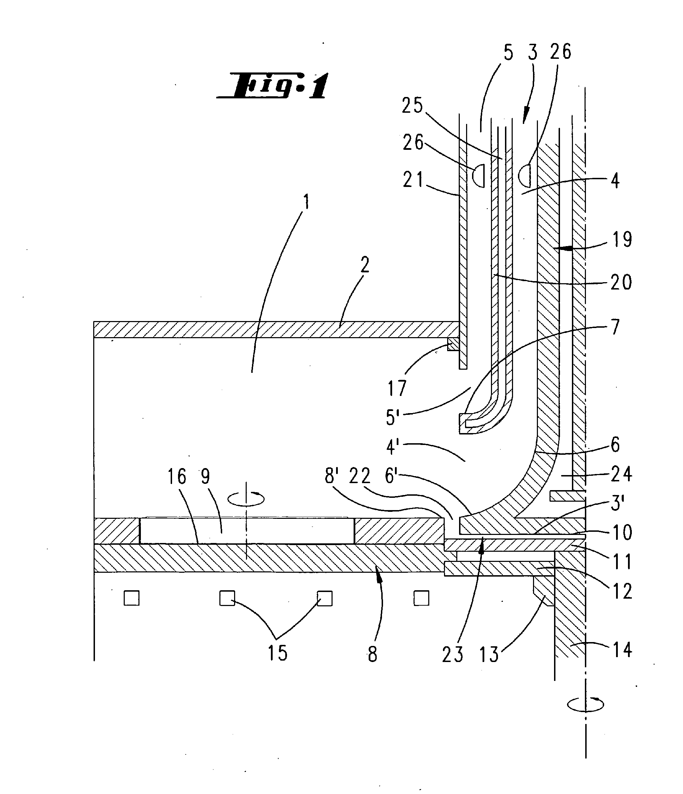

Nicht nur der zentrale Abschnitt 19 des Gaseinlassorganes 3 kann gekühlt werden. Es ist auch vorgesehen, dass das Mittelelement 20 gekühlt wird. Hierzu ist in der Figur 1 eine Kühlkammer 25 vorgesehen, die mit einer Kühlflüssigkeit durchströmt ist.

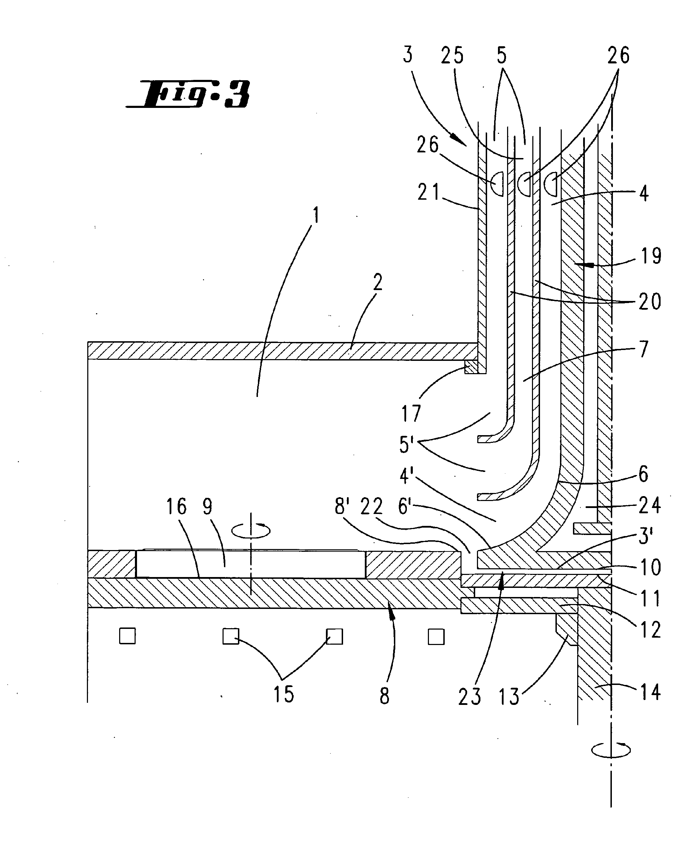

Das in der Figur 3 dargestellte weitere Ausführungsbeispiel der Erfindung besitzt insgesamt drei Austrittsöffnungen 4', 5', die in Vertikalrichtung übereinander angeordnet sind. Die zugehörigen Strömungskanäle 4, 5 besitzen ebenso wie das erste Ausführungsbeispiel Drallmischer 26, um die Gasverteilung im Bereich der Austrittsöffnungen 4', 5' in Umfangsrichtung zu homogenisieren. Die zusätzliche Gasaustrittsöffnung 5' bzw. der zusätzliche Strömungskanal 5 wird durch ein zusätzliches Mittelelement 20 ausgebildet.

Auch hier ist die Prozesskammerdecke 2 mit einer zentralen Öffnung versehen, deren Durchmesser größer ist als der Durchmesser des Gaseinlassorganes 3, so dass die Öffnung der Prozesskammerdecke 2 bei einem abgesenkten Suszeptorhalter 8 über das freie Ende des Gaseinlassorganes 3 gestülpt werden kann.

Alle offenbarten Merkmale sind (für sich) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen.

## Patentansprüche

1. Vorrichtung zum Abscheiden mindestens einer Schicht auf einem Substrat mittels eines Prozessgases, das durch einen sich in Vertikalrichtung erstreckenden Strömungskanal (4) eines in Bezug auf ein Reaktorgehäuse ortsfesten Gaseinlassorgans (3) in eine sich in Horizontalrichtung erstreckende Prozesskammer (1) eingebracht wird, wobei das Prozessgas aus einer Gasaustrittsöffnung eines in das Zentrum der rotationssymmetrischen Prozesskammer (1) ragenden Abschnitts des Gaseinlassorganes (3) austritt und über einen sich in Horizontalrichtung erstreckenden, um das Zentrum rotierenden Boden (8') der Prozesskammer (1) in Radialauswärtsrichtung strömt, auf welchem das Substrat liegt, **dadurch gekennzeichnet, dass** die Stirn (3') des Gaseinlassorganes (3) in eine topfartige Vertiefung (23) ragt und ein Endabschnitt (6') einer Gasumlenkfläche (6) mit dem Boden (8') fluchtet.

2. Vorrichtung nach Anspruch 1 oder insbesondere danach, **dadurch gekennzeichnet, dass** die Gasumlenkfläche gerundet ist und knick- und stufenfrei in die Wandung des Strömungskanals (4) übergeht.

3. Vorrichtung nach oder mehreren der vorangehenden Ansprüche oder insbesondere danach, **dadurch gekennzeichnet, dass** der Boden (8') von einem drehangetriebenen Suszeptorhalter (8) gebildet ist.

4. Vorrichtung nach einem oder mehreren der vorangehenden Ansprüche oder insbesondere danach, **dadurch gekennzeichnet, dass** der Suszeptorhalter (8) eine Vielzahl von drehangetriebenen Suszeptoren (9) trägt zur Aufnahme ein oder mehrerer Substrate.

5. Vorrichtung nach einem oder mehreren der vorangehenden Ansprüche oder insbesondere danach, **gekennzeichnet durch** mindestens eine weitere, oberhalb der Austrittsöffnung des ersten Strömungskanals (4) angeordnete zweite Gasauslassöffnung eines zweiten Strömungskanals.

6. Vorrichtung nach einem oder mehreren der vorangehenden Ansprüche oder insbesondere danach, **dadurch gekennzeichnet, dass** das Gaseinlassorgan (3) aus Stahl besteht.

7. Vorrichtung nach einem oder mehreren der vorangehenden Ansprüche oder insbesondere danach, **dadurch gekennzeichnet, dass** die Strömungskanäle innerhalb des Gaseinlassorganes (3) zumindest nahe des Bereichs der Gasaustrittsöffnungen konzentrisch angeordnet sind.

8. Vorrichtung nach einem oder mehreren der vorangehenden Ansprüche oder insbesondere danach, **dadurch gekennzeichnet, dass** das Gaseinlassorgan (3) Träger einer Prozesskammerdecke (2) ist und insbesondere einen Durchmesser aufweist, der geringer ist als der Durchmesser einer Öffnung der Prozesskammerdecke (2), so dass letzte über den in die Prozesskammer (1) ragenden Abschnitt des Gaseinlassorganes (3) gestülpt werden kann.

9. Vorrichtung nach einem oder mehreren der vorangehenden Ansprüche oder insbesondere danach, **dadurch gekennzeichnet, dass** die Prozesskammerdecke (2) bajonettartig an dem Gaseinlassorgan (3) befestigt ist.

10. Vorrichtung nach einem oder mehreren der vorangehenden Ansprüche oder insbesondere danach, **dadurch gekennzeichnet, dass** das Gaseinlassorgan (3) flüssigkeitsgekühlt ist.

11. Vorrichtung nach einem oder mehreren der vorangehenden Ansprüche oder insbesondere danach, **dadurch gekennzeichnet, dass** ein Kühlflüssigkeitskanal (24) bis in den in die Vertiefung (23) ragenden Abschnitt des Gaseinlassorganes (3) ragt.

## Claims

1. Apparatus for depositing at least one layer on a substrate by means of a process gas, which is introduced into a process chamber (1) that extends in a horizontal direction through a flow channel (4) of a gas inlet element (30), the flow channel extneding in a vertical direction and the gas inlet element being fixed in position on a reactor housing, the process gas exiting from a gas outlet opening of a portion of the gas inlet element (1) that projects into the center of the rotationally symmetrical process chamber (3) and flowing in a radially outward direction over a floor (8') of the process chamber (3), the floor extending in a horizontal direction and rotating about the center of the process chamber, and the substrate lying on the floor, **characterized in that** the end (3') of the gas inlet element (3) projects into a dish-like recess (23) and an end portion (6') of a gas-deflecting surface (6) is aligned with the floor (8').

2. Apparatus according to Claim 1 or in particular according thereto, **characterized in that** the gas-deflecting surface is rounded and merges into the wall of the flow channel (4) in a bend-free and step-free manner.

3. Apparatus according to one or more of the preceding claims or in particular according thereto, **characterized in that** the floor (8') is formed by a susceptor holder (8) that is driven in rotation.

4. Apparatus according to one or more of the preceding claims or in particular according thereto, **characterized in that** the susceptor holder (8) carries a plurality of susceptors (9) for receiving one or more substrates, the susceptors being driven in rotation.

5. Apparatus according to one or more of the preceding claims or in particular according thereto, **characterized by** at least one further second gas outlet opening of a second flow channel, disposed above the outlet opening of the first flow channel (4).

6. Apparatus according to one or more of the preceding claims or in particular according thereto, **characterized in that** the gas inlet element (3) consists of steel.

7. Apparatus according to one or more of the preceding claims or in particular according thereto, **characterized in that** the flow channels inside the gas inlet element (3) are arranged concentrically, at least near the region of the gas outlet openings.

8. Apparatus according to one or more of the preceding claims or in particular according thereto, **characterized in that** the gas inlet element (3) is carrier for a process chamber cover (2) and in particular has a diameter that is less that the diameter of an opening in the process chamber cover (2), so that the process chamber cover can be put over the portion of the gas inlet element (3) that projects into the process chamber (1).

9. Apparatus according to one or more of the preceding claims or in particular according thereto, **characterized in that** the process chamber cover (2) is secured to the gas inlet element (3) by a bayonet fitting.

10. Apparatus according to one or more of the preceding claims or in particular according thereto, **characterized in that** the gas inlet element (3) is fluid-cooled.

11. Apparatus according to one or more of the preceding claims or in particular according thereto, **characterized in that** a channel (24) for a fluid coolant extends into the portion of the gas inlet element (3) that projects into the recess (23).

## Revendications

1. Dispositif de dépôt d'au moins une couche sur un substrat au moyen d'un gaz de réaction qui est introduit dans une chambre de réaction (1), s'étendant dans une direction horizontale, par un canal d'écoulement (4), s'étendant dans une direction verticale, d'un organe d'admission de gaz (3) immobile par rapport à un boîtier de réacteur, le gaz de réaction sortant par une ouverture de sortie de gaz d'une portion de l'organe d'admission de gaz (3), qui fait saillie au centre de la chambre de réaction (1) à symétrie de révolution, et s'écoulant radialement vers l'extérieur au-dessus d'un fond (8') de la chambre de réaction (1), lequel s'étend dans une direction horizontale et tourne autour du centre et sur lequel le substrat repose, **caractérisé en ce que** la partie frontale (3') de l'organe d'admission de gaz (3) fait saillie dans un creux en cuvette (23) et une portion d'extrémité (6') d'une surface de déviation de gaz (6) s'aligne avec le fond (8').

2. Dispositif selon la revendication 1, ou notamment en conséquence de celle-ci, **caractérisé en ce que** la surface de déviation de gaz est arrondie et se transforme sans gradin ni coude en la paroi du canal d'écoulement (4).

3. Dispositif selon l'une ou plusieurs des revendications précédentes ou notamment en conséquence de celles-ci, **caractérisé en ce que** le fond (8') est formé par un porte-suscepteur (8) entraîné en rotation.

4. Dispositif selon l'une ou plusieurs des revendications précédentes ou notamment en conséquence de celles-ci, **caractérisé en ce que** le porte-suscepteur (8) supporte un grand nombre de suscepteurs (9) entraînés en rotation afin de recevoir un ou plusieurs substrats.

5. Dispositif selon l'une ou plusieurs des revendications précédentes ou notamment en conséquence de celles-ci, **caractérisé par** au moins une deuxième ouverture de sortie de gaz supplémentaire d'un deuxième canal d'écoulement, laquelle est disposée au-dessus de l'ouverture de sortie du premier canal d'écoulement (4).

6. Dispositif selon l'une ou plusieurs des revendications précédentes ou notamment en conséquence de celles-ci, **caractérisé en ce que** l'organe d'admission de gaz (3) est en acier.

7. Dispositif selon l'une ou plusieurs des revendications précédentes ou notamment en conséquence de celles-ci, **caractérisé en ce que** les canaux d'écoulement sont disposés concentriquement à l'intérieur de l'organe d'admission de gaz (3) au moins à proximité de la région des ouvertures de sortie de gaz.

8. Dispositif selon l'une ou plusieurs des revendications précédentes ou notamment en conséquence de celles-ci, **caractérisé en ce que** l'organe d'admission de gaz (3) est un support d'un couvercle de chambre de réaction (2) et a notamment un diamètre qui est inférieur au diamètre d'une ouverture du couvercle de chambre de réaction (2) de sorte que ce dernier peut être embouti par-dessus la portion de l'organe d'admission de gaz (3) qui fait saillie dans la chambre de réaction (1).

9. Dispositif selon l'une ou plusieurs des revendications précédentes ou notamment en conséquence de celles-ci, **caractérisé en ce que** le couvercle de chambre de réaction (2) est fixé à la manière d'une baïonnette à l'organe d'admission de gaz (3).

10. Dispositif selon l'une ou plusieurs des revendications précédentes ou notamment en conséquence de celles-ci, **caractérisé en ce que** l'organe d'admission de gaz (3) est refroidi par un liquide.

11. Dispositif selon l'une ou plusieurs des revendications précédentes ou notamment en conséquence de celles-ci, **caractérisé en ce qu'**un canal de liquide de refroidissement (24) fait saillie jusque dans la portion, saillant dans le creux (23), de l'organe d'admission de gaz (3).
